# FASCICULE DE BREVET EUROPEEN

(11) **EP 1 048 747 B1**
(45) Date de publication et mention de la délivrance du brevet: **20.07.2005**
(21) Numéro de dépôt: 00410038.4
(22) Date de dépôt: 14.04.2000
(51) Int. Cl.: C23C 16/48, H01L 21/00

(54) **Procédé et dispositif de traitement d'un matériau par rayonnement électromagnétique et sous atmosphère contrôlée**
Verfahren und Vorrichtung zur Behandlung eines Werkstoffes mit elektromagnetischer Strahlung in einer kontrollierten Atmosphäre
Process and apparatus for treating a material with electromagnetic radiation under a controlled atmosphere

(30) Priorité: 26.04.1999 FR 9905413
(43) Date de publication de la demande: 02.11.2000
(73) Titulaire: Joint Industrial Processors for Electronics, 72430 Noyen sur Sarthe (FR)
(72) Inventeur: Touchais Papet, Emmanuelle, Jip Elec, 38240 Meylan Zirst (FR); Ducret, René-Pierre, Jip Elec, 38240 Meylan Zirst (FR)
(74) Mandataire: Hecké, Gérard

(56) Documents cités:
- US-A- 5 441 569
- US-A- 5 863 327
- BOYD I W ET AL: "New large area ultraviolet lamp sources and their applications" NUCLEAR INSTRUMENTS & METHODS IN PHYSICS RESEARCH, SECTION - B: BEAM INTERACTIONS WITH MATERIALS AND ATOMS,NL,NORTH-HOLLAND PUBLISHING COMPANY. AMSTERDAM, vol. 121, no. 1, page 349-356 XP004057940 ISSN: 0168-583X
- SINGH R ET AL: "RAPID PHOTOTHERMAL PROCESSING" SOLID STATE TECHNOLOGY,US,COWAN PUBL.CORP. WASHINGTON, vol. 40, no. 10, page 193-194,196,198 XP000703998 ISSN: 0038-111X

## Description

### Domaine technique de l'invention

L'invention est relative à un procédé de traitement ou de formation d'un matériau par rayonnement électromagnétique et sous atmosphère contrôlée ou sous vide à intérieur d'une chambre de réaction, l'ensemble étant soumis à un premier rayonnement à infrarouge provoquant un chauffage rapide jusqu'à une température prédéterminée, de manière à modifier les propriétés physico-chimiques du matériau agencé sur un substrat, ou à réaliser un dépôt du matériau sur ledit substrat.

### Etat de la technique

Le matériau est généralement déposé sur un support formé par un substrat avec éventuellement des sous-couches intermédiaires. Le substrat est généralement constitué par du silicium dans le domaine de la microélectronique, mais il peut être également réalisé dans une autre matière, notamment en polymère, en verre ou en céramique. Les sous-couches peuvent être de natures très diverses et déposées au préalable sur le substrat par une technique appropriée. Un exemple de sous-couche peut être formé par un circuit imprimé, ou un revêtement isolant.

Pour modifier les propriétés physico-chimiques d'un matériau, il faut lui faire subir un recuit sous haute température, généralement supérieure à 1000°C avec les techniques de chauffage connues. Néanmoins si le substrat ou les sous-couches sont fragiles, il n'est pas possible d'utiliser une température élevée au risque de détruire le substrat ou les sous-couches.

Dans le domaine de la microélectronique, les applications de traitements thermiques rapides comme le recuit RTP et le dépôt en phase vapeur RTCVD sont mises en oeuvre dans des fours spéciaux sous vide ou sous atmosphère contrôlée. Dans le cas du RTP, un chauffage rapide du matériau à une température prédéterminée est obtenu afin de modifier par la suite les propriétés physico-chimiques du matériau soit pendant le maintien de la température, soit durant l'abaissement de la température. Dans le cas du RTCVD, un chauffage rapide d'une surface en contact avec des espèces gazeuses réactives permet de déposer une couche mince d'un matériau sur cette surface par réaction entre les espèces gazeuses et la surface chauffée.

Les traitements thermiques rapides doivent être stables et reproductibles, et interviennent généralement dans des fours à lampes à rayonnement infrarouge IR et à parois froides.

Au cours du déroulement des traitements thermiques, la température maximum atteinte pendant le chauffage rapide est très élevée, et peut être comprise entre 1000°C et 2000°C en fonction du type d'applications. La gamme des matériaux susceptibles d'être traités est ainsi limitée, car de plus en plus de substrats ne sont pas conçus pour résister à de fortes températures, notamment ceux réalisés à base de polymères, des matériaux à faible point de fusion, supports des composants CMOS, etc...

On connaît d'autre part l'action du rayonnement ultraviolet UV, pour modifier ou décomposer certains composés chimiques sous l'effet du rayonnement photonique UV. Parmi les sources de photons UV, on distingue les lampes UV classiques au xénon, mercure, deutérium ayant une large bande spectrale comprise entre 100-800 nm, et une puissance relativement faible. Il existe d'autre part des lasers du type CO₂, Nd : YAG, Ar, excimère, constituant des émetteurs coûteux ayant une bande centrale étroite, et une résolution spatiale réduite de l'ordre de quelques cm².

Le document US-A-4837484 décrit une lampe UV à décharge, bénéficiant d'une résolution spectrale étroite, d'une forte puissance, et d'une large résolution spatiale de plusieurs dizaines de cm². Ces lampes UV contiennent des gaz ou mélanges de gaz excimères, constitués par: Ar₂*, Kr₂*, Xe₂*, F₂*, Cl₂*, Br₂*, I₂* ArF*, ArCl*, KrCl*, XeCl*, HgNe*, HgAr*, HgKr*, HgXe*.

Le document US-A-5441569 décrit un dispositif de traitement pour des dépôts de couches minces, lequel fait usage de deux lasers, l'un à CO2, et l'autre excimère avec une longueur d'onde de 248nm. Les lasers présentent de petites surfaces de traitement, et le dispositif est dépourvu de chauffage à infrarouge.

Le document US-A-5863327 se rapporte à un appareil de traitement utilisant une source de radiation à infrarouge IR et une source de radiation à ultraviolet à lampes UV ayant des longueurs d'ondes comprises entre 50nm et 300nm. La résolution spatiale n'est pas précisée.

### Objet de l'invention

L'objet de l'invention consiste à mettre en oeuvre un procédé de traitement de surface consistant à abaisser la température de traitement ou de formation du matériau pour ne pas altérer la tenue du substrat ou des sous-couches, indépendamment de leurs natures ou compositions.

Le procédé selon l'invention est caractérisé en ce que :
- on utilise à l'intérieur de ladite chambre de réaction, un deuxième rayonnement UV à ultraviolet du type excimère ayant une résolution spectrale inférieure à 40 nm indépendamment de la longueur d'onde du rayonnement UV, de manière à engendrer un flux photonique adapté soit pour la modification des propriétés physico-chimiques du matériau (M), soit pour la formation dudit dépôt,
- la durée d'exposition du deuxième rayonnement UV est inférieure à celle du premier rayonnement IR,
- la température de traitement est comprise entre 70°C et 800°C en fonction de la nature du matériau.

L'action combinée du premier rayonnement à infrarouge et du deuxième rayonnement à ultraviolet excimère permet d'abaisser la température de traitement en fonction du type de matériau et du type de substrat. On pourra ainsi utiliser pour le substrat et les sous-couches, des matières ayant des tenues thermiques inférieures à celle du silicium.

Préférentiellement, la résolution spectrale du deuxième rayonnement UV à ultraviolet est de l'ordre de 10nm.

Selon une autre caractéristique de l'invention, le matériau, le mélange gazeux ou le liquide à traiter renferme un composé qui est photo-chimiquement sensible à la longueur d'onde du flux photonique du deuxième rayonnement UV excimère.

L'invention concerne également un dispositif de traitement comportant:
- des émetteurs infrarouge destinés à obtenir un premier rayonnement IR à infrarouge provoquant un chauffage rapide du substrat,
- des lampes à ultraviolet du type excimère susceptibles d'émettre un deuxième rayonnement UV à ultraviolet ayant une résolution spectrale inférieure à 40nm provoquant une modification des propriétés du matériau, du mélange gazeux ou du liquide à traiter,
- des hublots intercalés entre le substrat et les émetteurs infrarouge et les lampes à ultraviolet, et réalisés en un matériau transparent laissant passer le premier rayonnement IR et le deuxième rayonnement UV,
- et des réflecteurs intercalés entre la paroi de la chambre de réaction et les émetteurs infrarouge et les lampes à ultraviolet, pour obtenir une densité de puissance thermique optimum sur le substrat.

Le substrat est disposé dans la partie centrale de la chambre de réaction en étant soumis aux deux rayonnements opposés des émetteurs à infrarouge et des lampes à ultraviolets du type excimère.

Préférentiellement, la chambre de réaction en acier inoxydable à double paroi refroidie, comporte un système de pompage extérieur raccordé à un premier orifice pour travailler sous vide ou sous pression atmosphérique, et des moyens d'injection pour introduire un flux de gaz neutre ou réactif dans ladite chambre à travers un deuxième orifice.

Outre les applications de traitements thermiques du matériau, il existe deux autres applications possibles avec abaissement de la température au moyen d'un rayonnement UV excimère:
- la technique CVD de dépôt sous vapeur chimique qui fait réagir des espèces gazeuses avec une surface. Pour opérer la réaction, la surface est portée à une certaine température par le rayonnement IR, avec formation d'une couche de matériau issue de la réaction des espèces gazeuses sensibles au rayonnement UV sur la surface du substrat ;
- la technique de dépôt par décomposition d'un précurseur organométallique d'un matériau sur un support, consistant à étaler une couche de liquide, sol ou gel contenant au moins un organométallique sensible au rayonnement UV. Sous l'effet du rayonnement UV, l'organométallique se décompose en des espèces volatiles et une couche métallique ou autre, qui reste accrochée au substrat. Le rayonnement UV peut être complété par un chauffage infrarouge du substrat.

D'autres avantages et caractéristiques ressortiront plus clairement de la description qui va suivre d'un mode de réalisation de l'invention donné à titre d'exemple non limitatif, et représenté aux dessins annexés, dans lesquels :
- la figure 1 est une vue schématique du dispositif de traitement à chauffage combiné IR et UV selon l'invention ;
- la figure 2 est une vue identique d'une variante de réalisation.

### Description d'un mode de réalisation préférentiel

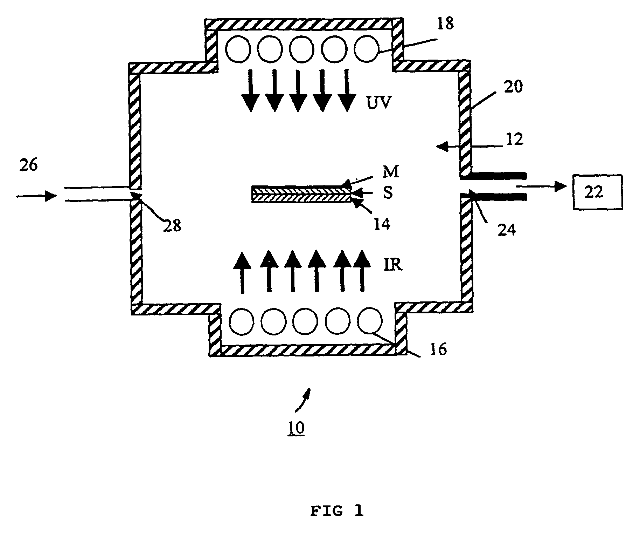

Sur la figure 1, le procédé mis en oeuvre dans le dispositif 10 permet d'abaisser la température de traitement grâce à l'intervention simultanée de deux sources de rayonnement à l'intérieur de la chambre de réaction 12 du four. Le matériau M est généralement déposé sur un support formé par un substrat 14 avec éventuellement des sous-couches S intermédiaires. Le traitement combiné du matériau M sur le substrat 14 résulte d'un premier rayonnement IR issu d'émetteurs infrarouge 16, et d'un deuxième rayonnement UV engendré par des lampes à ultraviolet du type excimère 18. Le substrat 14 est avantageusement disposé dans la zone médiane de la chambre de réaction 12 en étant encadré par les émetteurs IR 16 et les lampes UV 18.

Le flux énergétique produit par les émetteurs à infrarouge 16 peut atteindre plusieurs dizaine de kW, permettant de chauffer rapidement par rayonnement le substrat 14, et de le maintenir à une température prédéterminée pendant un temps donné.

Le flux photonique du deuxième rayonnement UV émis par les lampes à ultraviolet du type excimère 18 en vis à vis du premier rayonnement IR, agit sur la surface exposée en provoquant une modification des propriétés du matériau M (activation, densification, décomposition, etc...). Il peut atteindre 200 mW/cm².

La durée de l'exposition du deuxième rayonnement UV dépend des propriétés du matériau M à traiter, et des caractéristiques finales requises. La résolution spectrale des lampes à rayonnement ultraviolet du type excimère est choisie inférieure à 40 nm, indépendamment de la longueur d'onde du rayonnement UV émis par les lampes 18.

L'action des deux rayonnements IR et UV sur le matériau M permet d'obtenir une bonne homogénéité de chauffage et de rayonnement ultraviolet sur toute la surface du substrat 14. Il en résulte un traitement thermique à basse température, étant donné que le recuit est assisté par le deuxième rayonnement UV. Une large gamme de matériaux peut ainsi être traitée dans une telle chambre de réaction 12. La température de traitement est située dans une fourchette de 70°C à 800°C.

La chambre de réaction 12 est en acier inoxydable à double paroi 20 refroidie, et à atmosphère contrôlée. Un système de pompage 22 extérieur est raccordé à un premier orifice 24 de la chambre de réaction 12 pour travailler sous la pression atmosphérique ou abaisser la pression interne jusqu'à des vides secondaires.

Un flux de gaz 26 (neutre, réactif ou un mélange de gaz) peut être introduit par des moyens d'injection dans la chambre de réaction 12 à travers un deuxième orifice 28 pour réaliser des traitements sous atmosphère inerte ou réactive.

Sous atmosphère réactive, la surface exposée du support, constitué du substrat 14 éventuellement revêtu des sous-couches S, est en contact avec des espèces gazeuses avec lesquelles elle peut réagir, soit pour former une couche mince, soit pour modifier les propriétés physico-chimiques de la surface. Le deuxième rayonnement UV favorise cette réaction.

Lorsque le matériau est un composé photochimique sensible à la longueur d'onde des photons UV excimères, il peut être décomposé (cas des organométalliques) pour former une couche mince métallique, ou densifié (cas des ferroélectriques, ou des oxydes de silicium) pour modifier ses propriétés.

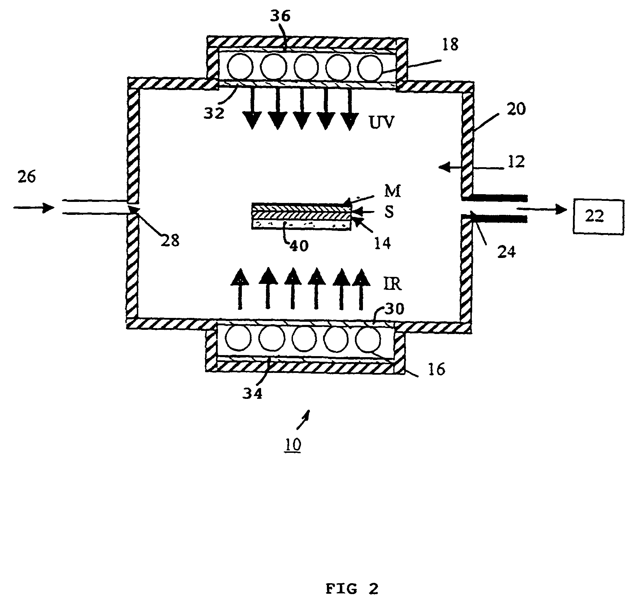

En référence à la figure 2, des hublots 30, 32 sont intercalés entre le substrat 14 et les émetteurs infrarouges 16 et les lampes à ultraviolet 18. Ils permettent d'isoler les émetteurs infrarouge 16 et les lampes à ultraviolet 18 de la chambre de réaction 12, et sont réalisés en un matériau transparent laissant passer le premier rayonnement IR et le deuxième rayonnement UV. Des réflecteurs 34, 36 sont agencés entre la paroi 20 de la chambre de réaction 12 et les émetteurs infrarouge 16 et les lampes à ultraviolet 18, pour obtenir une densité de puissance thermique optimum sur le substrat 14.

Le hublot 32 des lampes à ultraviolet 18 peut être remplacé par un contre tube agencé autour de chaque lampe. La présence du contre tube permet de réaliser une visée pyrométrique par intermédiaire d'un petit hublot ménagé dans le réflecteur 36 pour une régulation de température du substrat.

Le substrat 14 repose avantageusement sur un élément suscepteur 40 à base de graphite destiné à absorber le premier rayonnement IR.

## Revendications

1. Procédé de traitement ou de formation d'un matériau (M) par rayonnement électromagnétique et sous atmosphère contrôlée ou sous vide à l'intérieur d'une chambre de réaction (12), l'ensemble étant soumis à un premier rayonnement IR à infrarouge provoquant un chauffage rapide jusqu'à une température prédéterminée, de manière à modifier les propriétés physico-chimiques du matériau (M) agencé sur un substrat (14), ou à réaliser un dépôt du matériau (M) sur ledit substrat,
**caractérisé en ce que**
- simultanément on utilise à l'intérieur de ladite chambre de réaction (12), un deuxième rayonnement UV à ultraviolet du type excimère ayant une résolution spectrale inférieure à 40 nm indépendamment de la longueur d'onde du rayonnement UV, de manière à engendrer un flux photonique adapté soit pour la modification des propriétés physico-chimiques du matériau (M), soit pour la formation dudit dépôt, la durée d'exposition du deuxième rayonnement UV étant inférieure à celle du premier rayonnement IR, de manière à utiliser une température de traitement comprise entre 70°C et 800°C en fonction de la nature du matériau (M).

2. Procédé de traitement ou de formation d'un matériau selon la revendication 1, **caractérisé en ce que** la résolution spectrale du deuxième rayonnement UV à ultraviolet est de l'ordre de 10nm.

3. Procédé de traitement d'un matériau selon la revendication 1, **caractérisé en ce que** le matériau renferme un composé ayant une sensibilité photochimique à la longueur d'onde du flux photonique du deuxième rayonnement UV excimère, ledit matériau étant formé par un gel, sol, solide ou liquide.

4. Procédé de traitement d'un matériau selon la revendication 1, **caractérisé en ce que** la formation du dépôt par le deuxième rayonnement UV excimère s'effectue au moyen d'un gaz réactif qui réagit avec la surface du substrat pour réaliser une couche mince, ledit gaz renfermant un composé ayant une sensibilité photochimique.

5. Dispositif de traitement ou de formation d'un matériau (M) par rayonnement électromagnétique et sous atmosphère contrôlée ou sous vide à l'intérieur d'une chambre de réaction (12), et comprenant des émetteurs à infrarouge (16) destinés à obtenir un premier rayonnement IR à infrarouge provoquant un chauffage rapide du substrat (14),
**caractérisé en ce qu'**il comporte de plus :
- des lampes à ultraviolet (18) du type excimère susceptibles d'émettre un deuxième rayonnement UV à ultraviolet ayant une résolution spectrale inférieure à 40nm provoquant une modification des propriétés du matériau à traiter,
- des hublots (30, 32) intercalés entre le substrat (14) et les émetteurs infrarouge (16) et les lampes à ultraviolet (18), et réalisés en un matériau transparent laissant passer le premier rayonnement IR et le deuxième rayonnement UV,
- et des réflecteurs (34, 36) intercalés entre la paroi (20) de la chambre de réaction (12) et les émetteurs infrarouge (16) et les lampes à ultraviolet (18), pour obtenir une densité de puissance thermique optimum sur le substrat (14).

6. Dispositif de traitement selon la revendication 5, **caractérisé en ce que** le substrat (14) est disposé dans la partie centrale de la chambre de réaction (12) en étant soumis aux deux rayonnements opposés des émetteurs à infrarouge (16) et des lampes (18) à ultraviolet du type excimère.

7. Dispositif de traitement selon la revendication 6, **caractérisé en ce que** la chambre de réaction (12) est en acier inoxydable à double paroi (20) refroidie, et comporte un système de pompage (22) extérieur raccordé à un premier orifice (24) pour travailler sous vide ou sous pression atmosphérique, et des moyens d'injection d'un flux de gaz (26) neutre où réactif dans ladite chambre à travers un deuxième orifice (28).

8. Dispositif de traitement selon la revendication 5, **caractérisé en ce que** le substrat (14) repose sur un élément suscepteur (40) à base de graphite destiné à absorber le premier rayonnement IR.

## Patentansprüche

1. Verfahren zur Bearbeitung oder Bildung eines Werkstoffs (M) durch elektromagnetische Strahlung und in kontrollierter Atmosphäre oder unter Vakuum in einer Reaktionskammer (12), wobei das Ganze einer ersten Infrarot IR-Strahlung ausgesetzt wird, die eine schnelle Erwärmung bis auf eine vorbestimmte Temperatur bewirkt, wodurch die physikalisch-chemischen Eigenschaften des auf einem Substrat (14) angeordneten Werkstoffs (M) verändert werden oder sich der Werkstoff (M) auf diesem Substrat absetzt,
**dadurch gekennzeichnet, dass**
- in der Reaktionskammer (12) gleichzeitig eine zweite Ultraviolett UV-Strahlung vom Excimer Typ, mit einer Spektralauflösung unter 40 nm unabhängig von der Wellenlänge der UV-Strahlung, eingesetzt wird, in der Weise, dass ein geeigneter Photonfluss entweder zur Veränderung der physikalisch-chemischen Eigenschaften des Werkstoffs (M) oder zur Bildung der genannten Ablagerung entsteht, wobei die Dauer der Bestrahlung mit der zweiten UV-Strahlung kürzer als die der ersten IR-Strahlung ist, in der Weise, dass eine Behandlungstemperatur von 70 bis 800°C je nach Art des Werkstoffs (M) eingesetzt wird.

2. Verfahren zur Behandlung oder Bildung eines Werkstoffs nach Anspruch 1, **dadurch gekennzeichnet, dass** die Spektralauflösung der zweiten UV-Strahlung mit Ultraviolett bei etwa 10 nm liegt.

3. Verfahren zur Behandlung eines Werkstoffs nach Anspruch 1, **dadurch gekennzeichnet, dass** der Werkstoff eine Verbindung mit photochemischer Empfindlichkeit auf die Wellenlänge des Photonflusses der zweiten Excimer UV-Strahlung einschließt, welcher Werkstoff ein Gel, Sol, Feststoff oder eine Flüssigkeit sein kann.

4. Verfahren zur Behandlung eines Werkstoffs nach Anspruch 1, **dadurch gekennzeichnet, dass** die Bildung der Ablagerung durch die zweite, die Excimer UV-Strahlung mittels eines reaktiven Gases erfolgt, das mit der Oberfläche des Substrat reagiert, um eine dünne Schicht herzustellen, wobei dieses Gas eine Verbindung mit photochemischer Empfindlichkeit einschließt.

5. Vorrichtung zur Behandlung oder Bildung eines Werkstoffs (M) durch elektromagnetische Strahlung und in kontrollierter Atmosphäre oder unter Vakuum in einer Reaktionskammer (12) und umfassend Infrarotsender (16), die dazu bestimmt sind, eine erste Infrarot IR-Strahlung zu erzeugen, die eine schnelle Erwärmung des Substrats (14) bewirkt, **dadurch gekennzeichnet, dass** sie ferner umfasst:
- Ultraviolettlampen (18) der Excimer-Art, die geeignet sind, eine zweite Ultraviolett UV-Strahlung mit einer Spektralauflösung unter 40 nm auszustrahlen, die eine Veränderung der Eigenschaften des zu behandelnden Werkstoffs bewirkt,
- Gläser (30, 32), die zwischen dem Substrat (14) und den Infrarotsendern (16) und den Ultraviolettlampen (18) angeordnet sind und die aus einem transparenten Material bestehen, das sowohl die erste IR-Strahlung als auch die zweite UV-Strahlung durchlässt,
- und Reflektoren (34, 36), die zwischen der Wand (20) der Reaktionskammer (12) und den Infrarotsendern (16) und den Ultraviolettlampen (18) angeordnet sind, um auf dem Substrat (14) eine optimale Wärmeleistungsdichte zu erzeugen.

6. Behandlungsvorrichtung nach Anspruch 5, **dadurch gekennzeichnet, dass** das Substrat (14) im zentralen Bereich der Reaktionskammer (12) angeordnet ist, wobei es den zwei entgegengesetzten Strahlungen der Infrarotsender (16) und der Ultraviolettlampen (18) der Art Excimer ausgesetz wird.

7. Behandlungsvorrichtung nach Anspruch 6, **dadurch gekennzeichnet, dass** die Behandlungskammer (12) aus rostbeständigem Stahl mit einer gekühlten Doppelwand (20) besteht und ein außerhalb liegendes Pumpsystem (22), das an eine erste Öffnung (24) angeschlossen ist, um unter Vakuum oder atmosphärischem Druck zu arbeiten, sowie Mittel zur Einleitung eines Stroms (26) aus neutralem oder reaktivem Gas durch eine zweite Öffnung (28) in die Kammer umfasst.

8. Behandlungsvorrichtung nach Anspruch 5, **dadurch gekennzeichnet, dass** das Substrat (14) auf einem Suszeptorelement (40) auf Basis von Graphit angeordnet ist, die die erste IR-Strahlung absorbieren soll.

## Claims

1. A process for treating or forming a material (M) by electromagnetic radiation and in a controlled atmosphere or in a vacuum inside a reaction chamber (12), the assembly being subjected to a first infrared radiation IR causing rapid heating to a preset temperature so as to modify the physico-chemical properties of the material (M) arranged on a substrate (14) or to perform deposition of the material (M) on said substrate,
**characterized in that**
- a second ultraviolet radiation UV of excimer type, having a spectral resolution lower than 40 nm regardless of the wavelength of the radiation UV is simultaneously used inside said reaction chamber (12) so as to generate a photon flux suitable either for modification of the physico-chemical properties of the material (M) or for formation of said deposit, the exposure time of the second radiation UV is shorter than that of the first radiation IR, so as to use a treating temperature comprised between 70°C and 800°C according to the nature of the material (M).

2. The process for treating or forming a material according to claim 1, **characterized in that** the spectral resolution of the second ultraviolet radiation UV is about 10 nm.

3. The process for treating a material according to claim 1, **characterized in that** the material contains a compound having a photochemical sensitivity to the wavelength of the photon flux of the second excimer radiation UV, said material being formed by a gel, sol, solid or liquid.

4. The process for treating a material according to claim 1, **characterized in that** the formation of the deposit by the second excimer radiation UV is achieved by means of a reactive gas which reacts with the surface of the substrate to achieve a thin layer, said gas containing a compound having a photochemical sensitivity.

5. A device for treating or forming a material (M) by electromagnetic radiation and in a controlled atmosphere or in a vacuum inside a reaction chamber (12), and comprising infrared emitters (16) designed to obtain a first infrared radiation IR causing rapid heating of the substrate (14),
**characterized in that** it comprises in addition:
- ultraviolet lamps (18) of the excimer type capable of emitting a second ultraviolet radiation UV having a spectral resolution lower than 40 nm causing a modification of the properties of the material to be treated,
- windows (30, 32) inserted between the substrate (14) and the infrared emitters (16) and ultraviolet lamps (18) and made of a transparent material letting the first radiation IR and the second radiation UV pass,
- and reflectors (34, 36) inserted between the wall (20) of the reaction chamber (12) and the infrared emitters (16) and ultraviolet lamps (18) to obtain an optimum thermal power density on the substrate (14).

6. The treating device according to claim 5, **characterized in that** the substrate (14) is arranged in the central part of the reaction chamber (12) and is subjected to the two opposite radiation from the infrared emitters (16) and the ultraviolet lamps of the excimer type (18).

7. The treating device according to claim 6, **characterized in that** the reaction chamber (12) is made of stainless steel with a cooled double wall (20), and comprises an external pumping system (22) connected to a first orifice (24) to work in a vacuum or at atmospheric pressure and means for injecting a flow of neutral or reactive gas (26) to said chamber via a second orifice (28).

8. The treating device according to claim 5, **characterized in that** the substrate (14) is located upon a graphite-based susceptor element designed to absorb the first radiation IR.
